Europäisches Patentamt

European Patent Office

Office européen des brevets

(19)

(11) **EP 0 835 550 B1**

(12) **FASCICULE DE BREVET EUROPEEN**

(45) Date de publication et mention
de la délivrance du brevet:
**13.01.1999 Bulletin 1999/02**

(21) Numéro de dépôt: **96924015.9**

(22) Date de dépôt: **24.06.1996**

(51) Int Cl.⁶: **H03D 13/00**

(86) Numéro de dépôt international:
**PCT/FR96/00986**

(87) Numéro de publication internationale:
**WO 97/01884 (16.01.1997 Gazette 1997/04)**

(54) **COMPARATEUR DE PHASE SANS ZONE MORTE**

PHASENKOMPARATOR OHNE TOTBEREICH

PHASE COMPARATOR WITHOUT DEAD ZONE

(84) Etats contractants désignés:
**DE GB IT**

(30) Priorité: **27.06.1995 FR 9507718**

(43) Date de publication de la demande:
**15.04.1998 Bulletin 1998/16**

(73) Titulaire: **MATRA NORTEL COMMUNICATIONS**
**29000 Quimper (FR)**

(72) Inventeur: **ROBBE, Michel**
**F-78700 Conflans-Sainte-Honorine (FR)**

(74) Mandataire: **Loisel, Bertrand**
**Cabinet Plasseraud,**
**84, rue d'Amsterdam**
**75440 Paris Cédex 09 (FR)**

(56) Documents cités:
**GB-A- 2 055 268**   **US-A- 4 023 116**
**US-A- 5 373 255**

**Description**

La présente invention concerne un comparateur de phase entre des premier et second signaux binaires d'entrée, du type comprenant :

- une logique de détection de déphasage recevant les signaux d'entrée avec des retards prédéterminés respectifs, et délivrant d'une part un premier signal de détection activé, après un front actif du premier signal d'entrée retardé précédant un front actif du second signal d'entrée retardé, pendant une durée correspondant à l'intervalle de temps entre lesdits fronts actifs des signaux d'entrée retardés, et d'autre part un second signal de détection activé, après un front actif du second signal d'entrée retardé précédant un front actif du premier signal d'entrée retardé, pendant une durée correspondant à l'intervalle de temps entre lesdits fronts actifs des signaux d'entrée retardés ;
- un premier générateur de signal impulsionnel, produisant un premier signal impulsionnel présentant une impulsion active de durée déterminée après chaque front actif du premier signal d'entrée, de manière à ce que chaque front d'activation du premier signal de détection et chaque front de désactivation du second signal de détection surviennent pendant que le premier signal impulsionnel est actif ;
- une logique de commande de transfert de charges combinant au moins les signaux de détection et le premier signal impulsionnel, et produisant des premier et second signaux de commande non simultanément actifs ; et
- un circuit formant pompe de charge pour faire varier dans un sens la valeur d'une tension de sortie lorsque le premier signal de commande est actif et pour faire varier dans l'autre sens la valeur de la tension de commande lorsque le second signal de commande est actif.

Les comparateurs de phase de ce type sont notamment utilisés dans des boucles à phase asservie (PLL). Dans cette application, l'un des signaux d'entrée est par exemple issu d'un oscillateur commandé en tension, généralement après une division de fréquence, et l'autre signal d'entrée est un signal de référence. La tension de sortie du comparateur de phase est intégrée par un filtre passe-bas dont la sortie commande l'oscillateur de manière à aligner les phases des deux signaux d'entrée.

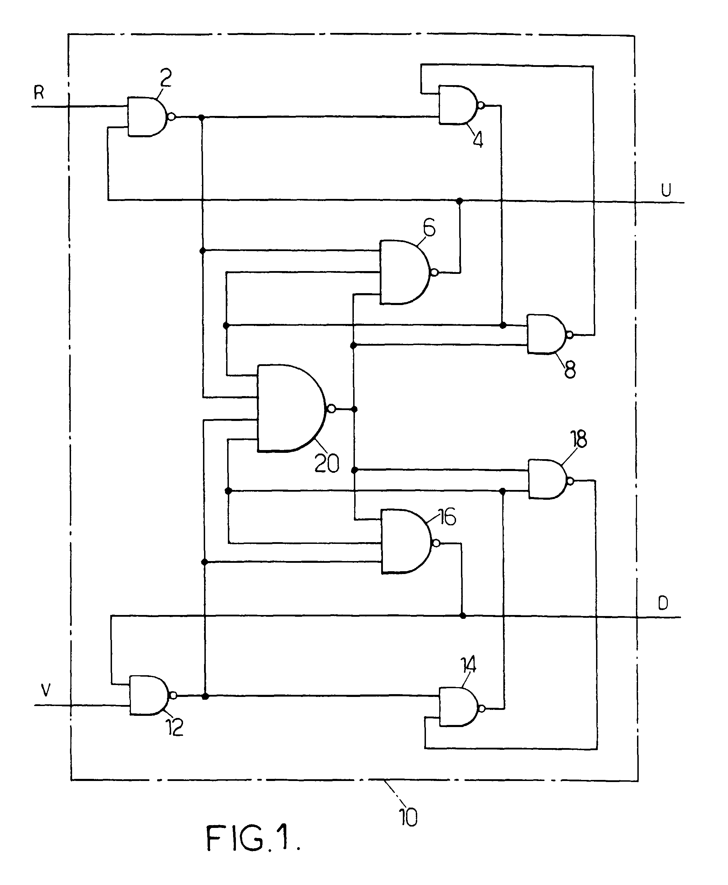

La figure 1 illustre un exemple de logique de détection de déphasage 10, appelée comparateur à neuf portes, utilisable dans un tel comparateur de phase. Les signaux d'entrée retardés R et V (les retards affectés aux signaux d'entrée sont généralement nuls dans les comparateurs connus) sont appliqués chacun à une entrée d'une porte NON ET respective 2, 12 à deux entrées. La sortie de la porte 2 est reliée à une entrée d'une porte NON ET 4 à deux entrées, à une entrée d'une porte NON ET 6 à trois entrées, et à une entrée d'une porte NON ET 20 à quatre entrées. La sortie de la porte 6 fournit le premier signal de détection U et est reliée à l'autre entrée de la porte 2. La sortie de la porte 4 est reliée à une autre entrée de la porte 6, à une autre entrée de la porte 20, et à une entrée d'une porte NON ET 8 à deux entrées. La dernière entrée de la porte 6, ainsi que l'autre entrée de la porte 8 sont reliées à la sortie de la porte 20. L'autre entrée de la porte 4 est reliée à la sortie de la porte 8. La sortie de la porte 12 est reliée à une entrée d'une porte NON ET 14 à deux entrées, à une entrée d'une porte NON ET 16 à trois entrées, et à une autre entrée de la porte 20. La sortie de la porte 16 fournit le second signal de détection D et est reliée à l'autre entrée de la porte 12. La sortie de la porte 14 est reliée à une autre entrée de la porte 16, à la dernière entrée de la porte 20, et à une entrée d'une porte NON ET 18 à deux entrées. La sortie de la porte 20 est également reliée à la dernière entrée de la porte 16 et à l'autre entrée de la porte 18. La sortie de la porte 18 est reliée à l'autre entrée de la porte 14.

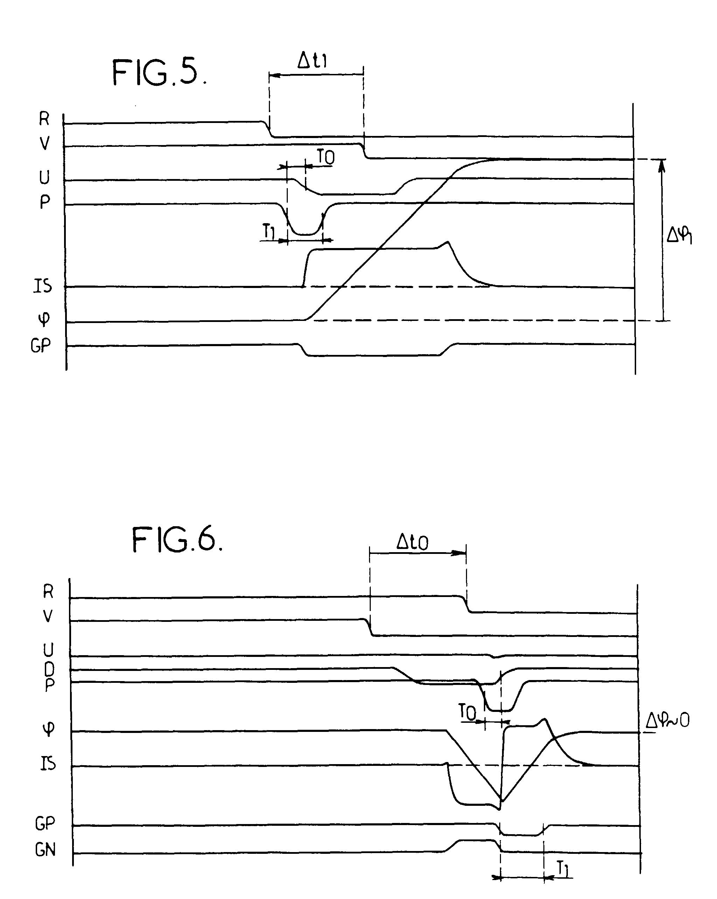

Avec ce comparateur de phase à neuf portes 10, les fronts actifs des signaux d'entrée sont des fronts descendants. Lorsque le front descendant du premier signal d'entrée R précède un front descendant du second signal d'entrée V, le premier signal de détection U présente une impulsion active de niveau logique 0 dont la durée correspond à l'intervalle de temps séparant les fronts descendants des signaux R et V, tandis que le second signal de détection D reste inactif au niveau logique 1 (voir figure 5). Symétriquement, lorsque le front descendant du second signal d'entrée V précède un front descendant du premier signal d'entrée R, le second signal de détection D présente une impulsion active de niveau logique 0 dont la durée correspond à l'intervalle séparant les deux fronts descendants des signaux V et R, tandis que le premier signal de détection U reste inactif au niveau logique 1 (voir figure 6). Les signaux de détection U, D restent inactifs (U=D=1) lorsque les fronts descendants des signaux d'entrée R et V sont concomitants.

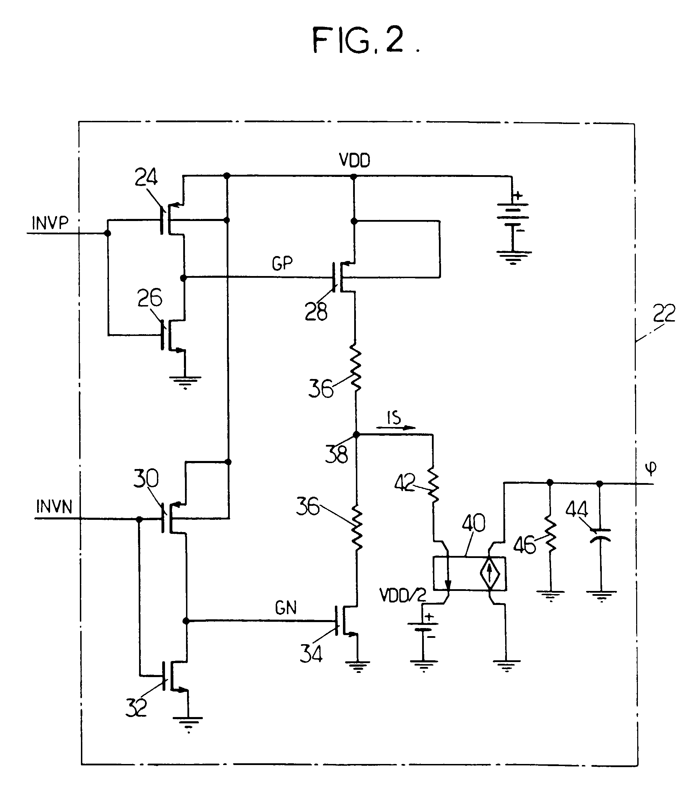

La figure 2 illustre un exemple de circuit 22 formant pompe de charge utilisable dans un comparateur de phase du type indiqué au début. Cette pompe de charge 22 comprend un premier inverseur CMOS recevant le premier signal de commande INVP, constitué par un transistor PMOS 24 dont la source est à une tension positive VDD et par un transistor NMOS 26 dont la source est à la masse. Le drain commun des transistors 24 et 26 fournit le premier signal de commande inversé GP appliqué à un autre transistor PMOS 28 dont la source est à la tension positive VDD. La pompe de charge 22 comprend en outre un autre inverseur CMOS recevant le second signal de commande INVN, constitué par un transistor PMOS 30 dont la source est à la tension positive VDD et par un transistor NMOS 32 dont la source est à la masse. Le drain commun des transistors 30 et 32 fournit le second signal de commande inversé GN appliqué à la grille d'un autre transistor NMOS 34 dont la source est à la masse. Deux résistances de même valeur 36 relient respectivement les drains des transistors 28 et 34 à un noeud commun 38. La pompe de charge 22 comprend en outre un transformateur de courant 40 de gain 1 dont le primaire a une borne reliée au noeud 38 par l'intermédiaire d'une résistance 42 et une borne portée à une tension positive VDD/2, et dont le secondaire a une borne à la masse et une borne reliée à la masse par l'intermédiaire d'une part d'un condensateur d'intégration 44, et d'autre part d'une résistance d'intégration 46. Cette dernière borne délivre la tension de sortie φ du comparateur.

Le premier signal de commande INVP est actif au niveau logique 1. Lorsque INVP=1, le transistor PMOS 28 est passant, et le condensateur 44 se charge positivement sous l'effet d'un courant IS positif, ce qui augmente la valeur de la tension de sortie φ. Le second signal de commande INVN est actif au niveau logique 0. Lorsque INVN=0, le transistor NMOS 34 est passant, et le condensateur 44 se charge négativement sous l'effet d'un courant IS négatif, ce qui diminue la tension de sortie φ.

Pour limiter l'amplitude des fluctuations de la tension de sortie, on utilise normalement dans la pompe de charge 22 une tension positive VDD plus petite que celle utilisée dans les circuits logiques situés en amont, par exemple VDD=+2,5V.

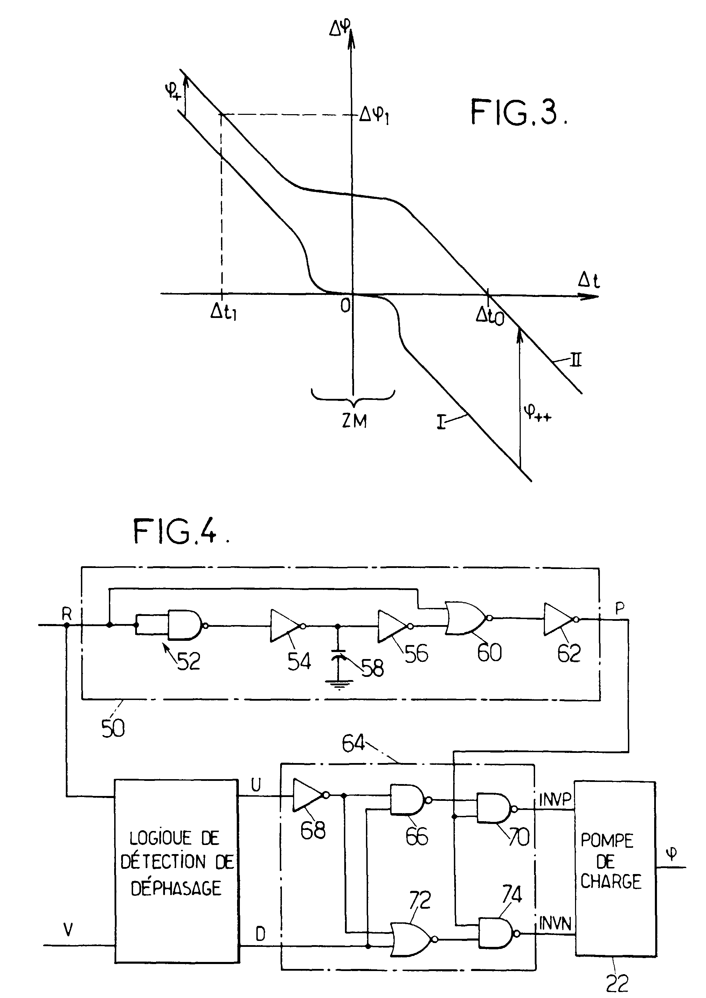

Si les signaux de commande INVP, INVN étaient directement déduits des signaux de détection U,D fournis par le comparateur à neuf portes 10 (c'est-à-dire INVP=$\overline{U}$ et INVN=D ou encore, pour garantir que les signaux de commande ne se trouvent jamais simultanément actifs, INVP=$\overline{U}$ *ET* D et INVN=$\overline{U}$ *OU* D), la réponse du comparateur aurait l'allure représentée par la courbe I sur la figure 3. Sur ce graphique, les abscisses représentent le décalage temporel $\Delta t$ entre les fronts descendants des signaux R et V ($\Delta t>0$ si le front descendant du signal d'entrée V précède le front descendant du signal d'entrée R), et les ordonnées représentent la variation $\Delta \varphi$ de la tension de sortie φ du comparateur. La courbe I représente une caractéristique sensiblement linéaire du comparateur, mais il existe, autour du décalage $\Delta t=0$ une zone ZM de gain quasiment nul, appelée zone morte. Cette zone morte est due à la durée non nulle des changements d'états dans les portes de la logique de détection de déphasage 10, et aux incertitudes sur les niveaux analogiques des seuils de décision binaire. Lorsque le décalage temporel est très faible, les signaux de détection n'ont pas le temps d'atteindre le niveau actif, de sorte qu'il n'est pas fait de distinction avec un décalage temporel nul. La zone morte représente une incertitude qui est par exemple de l'ordre de ±1,5 ns autour de $\Delta t=0$. Une telle zone morte empêche la boucle à phase asservie comportant le comparateur de fonctionner convenablement.

Pour contourner ce problème de la zone morte, les comparateurs de phase traditionnels sont agencés pour décaler le long de l'axe des ordonnées la caractéristique I de la figure 3, de façon à obtenir une caractéristique telle que II. Ceci est réalisé au moyen du générateur de signal impulsionnel et de la logique de commande de transfert de charge mentionnés en introduction, dont un exemple classique de réalisation est représenté sur la figure 4.

Dans l'exemple de la figure 4, le générateur 50 produit un signal impulsionnel P présentant une impulsion active après chaque front actif du premier signal d'entrée R. Ce générateur 50 comprend trois inverseurs en cascade 52, 54, 56, dont le premier 52 reçoit le signal d'entrée R. Un condensateur de temporisation 58 est connecté entre la masse et l'entrée du troisième inverseur 56. Le générateur 50 comporte en outre une porte NI 60 et un inverseur 62. La porte NI 60 a deux entrées reliées respectivement à l'entrée de l'inverseur 52 et à la sortie de l'inverseur 56, et sa sortie est reliée à l'entrée de l'inverseur 62. Le premier signal impulsionnel P est disponible en sortie de l'inverseur 62. Le signal P est inactif au niveau logique 1. Lorsque survient un front descendant du signal d'entrée R, le signal P s'active au niveau 0 après le temps de réponse des portes 60 et 62 qui est plus petit que celui de la logique de détection 10, et il reste à ce niveau 0 pendant une durée $T_1$ déterminée principalement par la capacité du condensateur 58. Cette capacité est choisie de façon à ce que chaque front des signaux de détection U, D provoqué par le front descendant du signal d'entrée R (c'est-à-dire chaque front descendant de U et chaque front montant de D) survienne pendant l'impulsion active du signal P.

La logique de commande 64 combine les signaux de détection U, D fournis par la logique de détection de déphasage 10 et le signal impulsionnel P fourni par le générateur 50, pour produire les signaux de commande INVP, INVN destinés à la pompe de charge 22. La logique de commande 64 comprend, dans l'exemple représenté sur la figure 4, une porte NON ET 66 dont une entrée reçoit le signal de détection U inversé par un inverseur 68 et l'autre entrée reçoit l'autre signal de détection D. La sortie de la porte 66 est reliée à une entrée d'une autre porte NON ET 70 dont l'autre entrée reçoit le signal impulsionnel P. Le signal de commande INVP est disponible à la sortie de la porte 70, de sorte qu'on réalise INVP = $\overline{P}$ *OU* ($\overline{U}$ *ET* D). La logique de commande 64 comporte en outre une porte NI 72 dont une entrée reçoit le signal de détection D et l'autre entrée reçoit l'autre signal de détection U inversé par l'inverseur 68. La sortie de la porte NI 72 est reliée à une entrée d'une porte NON ET 74 dont l'autre entrée reçoit le signal impulsionnel P. Le signal de commande INVN est disponible à la sortie de la porte NON ET 74, de sorte qu'on réalise INVN = $\overline{P}$ *OU* $\overline{U}$ *OU* $\overline{D}$.

Un courant IS positif est toujours injecté par la pompe de charge 22 lorsque le signal impulsionnel P est actif (après le temps de réponse des transistors de la logique de commande et de la pompe de charge). Lorsque le front descendant du signal R précède celui du signal V (figure 5), l'impulsion P prolonge l'activation du signal de commande INVP due au signal de détection U d'une durée $T_0$ approximativement égale à la différence entre le temps de réponse de la logique de détection de déphasage 10 aux fronts descendants du signal d'entrée R et le temps de réponse du générateur 50 aux fronts descendants du signal d'entrée R. En dehors de la zone morte, la caractéristique du comparateur pour $\Delta t < 0$ est donc décalée vers le haut d'une quantité $\varphi_+$ proportionnelle à $T_0$ (figure 3). Lorsque le front descendant du signal V précède celui du signal R (figure 6), l'impulsion P provoque l'activation du signal de commande INVP pendant la durée $T_1$, et raccourcit l'activation du signal de commande INVN due au signal de détection D d'une durée approximativement égale à $T_0$. En dehors de la zone morte, la caractéristique du comparateur pour $\Delta t > 0$ est donc décalée vers le haut d'une quantité $\varphi_{++}$ proportionnelle à $T_0+T_1$ (figure 3).

L'asservissement apporté par la PLL est tel que le comparateur de phase fonctionne autour du point $\Delta \varphi = 0$ qui correspond à un décalage temporel positif $\Delta t_0$ (cas de la figure 6), qui est par exemple de l'ordre de 5 ns. Le comparateur peut ainsi fonctionner sur une partie linéaire de sa caractéristique II, dans le cas fréquent où les fluctuations de phase des signaux d'entrée sont de relativement petite amplitude.

Mais un inconvénient des comparateurs de phase connus du type ci-dessus est que la zone morte ZM subsiste, comme le montre la figure 3. Elle peut même être élargie puisque l'impulsion P empêche la distinction entre les impulsions actives du signal U de durée plus petite que $T_1-T_0$ et les impulsions actives du signal D de durée plus petite que $T_0$. Si les fluctuations de phase des signaux d'entrée deviennent importantes, la zone morte peut être atteinte et rendre la boucle instable. Cela se produit par exemple si les deux signaux d'entrée sont des signaux à modulation de fréquence avec une excursion en fréquence relativement importante. Ce problème est en général traité en augmentant la capacité du ou des condensateurs 58 déterminant la durée $T_1$ des impulsions P, pour augmenter le décalage à l'origine $\Delta t_0$. Mais ceci génère d'autres difficultés. En particulier la tension de sortie $\varphi$ à l'équilibre (figure 6) présente une impulsion de largeur de l'ordre de $T_1$. Si on augmente la valeur de $T_1$, cette impulsion a une amplitude qui augmente, et elle peut atteindre une largeur non négligeable vis-à-vis de la période d'oscillation lorsque la fréquence est élevée. Ainsi des impulsions de 100 ns par exemple pour des signaux modulés autour de 1MHz représentent 10% de la période, et sont mal filtrées par le filtre passe-bas, de sorte qu'elles perturbent le spectre de sortie de l'oscillateur commandé en tension.

Un but principal de la présente invention est de fournir un comparateur de phase sans zone morte.

L'invention propose ainsi un comparateur de phase du type mentionné en introduction, comprenant en outre des moyens pour produire un signal de séparation passant d'un premier niveau à un second niveau avec un retard fixe après chaque front actif du second signal d'entrée, et un second générateur de signal impulsionnel, produisant un second signal impulsionnel présentant une impulsion active de durée fixe après chaque front actif du second signal d'entrée, de manière à ce que chaque front de désactivation du premier signal de détection, chaque front d'activation du second signal de détection et chaque passage du signal de séparation du premier au second niveau surviennent pendant que le second signal impulsionnel est actif. La logique de commande combine les premier et second signaux de détection, les premier et second signaux impulsionnels et le signal de séparation de manière à ce que, pendant que l'un au moins des signaux impulsionnels est actif, le premier signal de commande soit actif si le signal de séparation est au premier niveau, et le second signal de commande soit actif si le signal de séparation est au second niveau.

L'invention sera mieux comprise à la lecture de la description ci-après d'un exemple de réalisation préféré mais non limitatif, en référence aux dessins annexés, dans lesquels :

- la figure 1 est un schéma classique d'une logique de détection de déphasage utilisable dans un comparateur selon l'invention ;

- la figure 2 est un schéma classique d'une pompe de charge utilisable dans un comparateur selon l'invention ;

- la figure 3 est un graphique montrant les caractéristiques de comparateurs de phase de l'art antérieur ;

- la figure 4 est un schéma d'un comparateur de phase de l'art antérieur ;

- les figures 5 et 6 sont des chronogrammes illustrant le fonctionnement du comparateur de la figure 4 ;

- la figure 7 est un schéma d'un comparateur de phase selon l'invention ;

- les figures 8 à 12 sont des chronogrammes illustrant le fonctionnement du comparateur de la figure 7 ;

- la figure 13 est un graphique montrant la caractéristique du comparateur de phase de la figure 7 ; et

- la figure 14 est un schéma montrant une variante de réalisation d'une logique de commande de transfert de charges dans un comparateur de phase tel que celui de la figure 7.

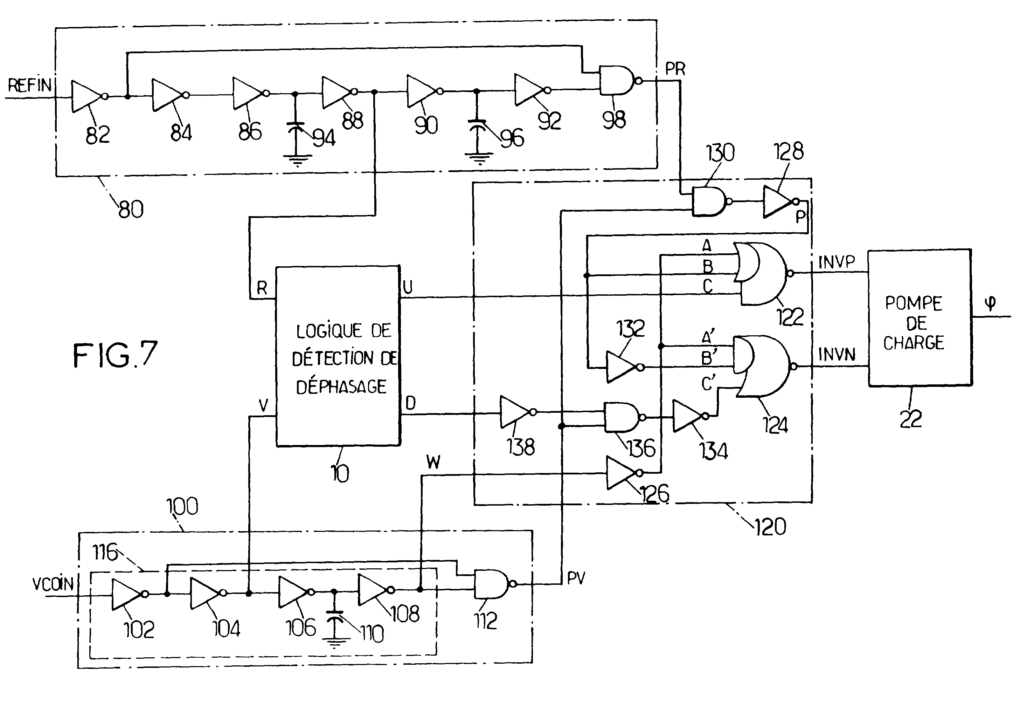

Le comparateur représenté sur la figure 7 reçoit deux signaux binaires d'entrée REFIN, VCOIN. Le premier signal d'entrée REFIN est par exemple un signal radiofréquence de référence de la PLL à laquelle appartient le comparateur, tandis que le second signal d'entrée VCOIN provient par exemple de l'oscillateur commandé en tension de la PLL après une division de fréquence appropriée. La tension de sortie $\varphi$ du comparateur est intégrée pour commander l'oscillateur de manière à asservir le déphasage du signal VCOIN à une valeur constante par rapport au signal REFIN.

Le comparateur de phase comprend une logique de détection de déphasage 10 et une pompe de charge 22 qui sont par exemple du type décrit précédemment en référence aux figures 1 et 2. Il comprend en outre deux générateurs de signaux impulsionnels 80, 100, et une logique de commande de transfert de charges 120.

Le générateur 80 reçoit le premier signal d'entrée REFIN et délivre un signal impulsionnel PR qui présente une impulsion active de niveau logique 0 après chaque front descendant du signal REFIN. Le générateur 80 représenté à titre d'exemple sur la figure 7 comporte six inverseurs en cascade 82, 84, 86, 88, 90 et 92, deux condensateurs de temporisation 94 et 96, l'un connecté entre la sortie du troisième inverseur 86 et la masse et l'autre connecté entre la sortie du cinquième inverseur 90 et la masse, et une porte NON ET 98 dont la sortie fournit le signal impulsionnel PR. Les deux entrées de la porte NON ET 98 sont respectivement reliées à la sortie du premier inverseur 82 et à la sortie du sixième inverseur 92. La sortie du quatrième inverseur 88 fournit le premier signal d'entrée retardé R à la première entrée de la logique de détection 10.

Le générateur 100 reçoit le second signal d'entrée VCOIN et délivre un signal impulsionnel PV qui présente une impulsion active de niveau logique 0 après chaque front descendant du signal VCOIN. Le générateur 100 représenté à titre d'exemple sur la figure 7 comporte quatre inverseurs en cascade 102, 104, 106 et 108, un condensateur de temporisation 110 connecté entre la sortie du troisième inverseur 106 et la masse, et une porte NON ET 112 dont la sortie fournit le signal impulsionnel PV. Les deux entrées de la porte NON ET 112 sont respectivement reliées à la sortie du premier inverseur 102 et à la sortie du quatrième inverseur 108. La sortie du second inverseur 104 fournit le second signal d'entrée retardé V à la seconde entrée de la logique de détection 10.

Le comparateur de phase comprend en outre des moyens 116 pour produire un signal de séparation W passant d'un premier niveau à un second niveau avec un retard fixe après chaque front descendant du second signal d'entrée VCOIN. Dans l'exemple représenté sur la figure 7, le signal de séparation W est simplement la version retardée du signal VCOIN disponible à la sortie du quatrième inverseur 108. Les moyens 116 sont alors constitués par les inverseurs 102 à 108 et le condensateur 110 appartenant au générateur 100.

La logique de commande 120 reçoit les deux signaux de détection U,D produits par la logique 10, les deux signaux impulsionnels PR, PV produits par les générateurs 80, 100 et le signal de séparation W produit par les moyens 116, et combine ces cinq signaux pour obtenir les deux signaux de commande INVP, INVN adressés à la pompe de charge 22. Dans l'exemple de la figure 7, la logique de commande 120 comprend deux portes logiques composites à trois entrées 122, 124 délivrant respectivement les signaux de commande INVP et INVN. La porte 122 réalise l'opération logique $\overline{INVP}$ = (A OU B) ET C entre les signaux A, B et C parvenant respectivement à ses trois entrées. Le signal A est fourni par un inverseur 126 dont l'entrée reçoit le signal de séparation W. Le signal B correspond à un signal P qui est au niveau logique 0 lorsque l'un au moins des deux signaux impulsionnels PR, PV est actif au niveau 0. Le signal P est fourni par un inverseur 128 relié à la sortie d'une porte NON ET 130 dont les deux entrée reçoivent respectivement les signaux impulsionnels PR et PV. Le signal C correspond au premier signal de détection U. La logique de commande 120 réalise ainsi l'opération logique :

$$INVP = \overline{U} \; OU \; [W \; ET \; (\overline{PR} \; OU \; \overline{PV})] \qquad (1)$$

La porte 124 réalise l'opération logique $\overline{INVN}$ = (A' ET B') OU C' entre les signaux A', B' et C' parvenant respectivement à ses trois entrées. Le signal A' est celui fourni par l'inverseur 126. Le signal B' correspond au complément logique du signal P fourni par un inverseur 132. Le signal C' est fourni par un inverseur 134 relié à la sortie d'une porte NON ET 136. Une entrée de la porte 136 reçoit le second signal impulsionnel PV. L'autre entrée de la porte 136 reçoit le complément logique du second signal de détection D fourni par un inverseur 138. La logique de commande 120 réalise ainsi l'opération logique :

$$\overline{INVN} =$$
$$(\overline{D} \; ET \; PV) \; OU \; [\overline{W} \; ET \; (\overline{PR} \; OU \; \overline{PV})] \qquad (2)$$

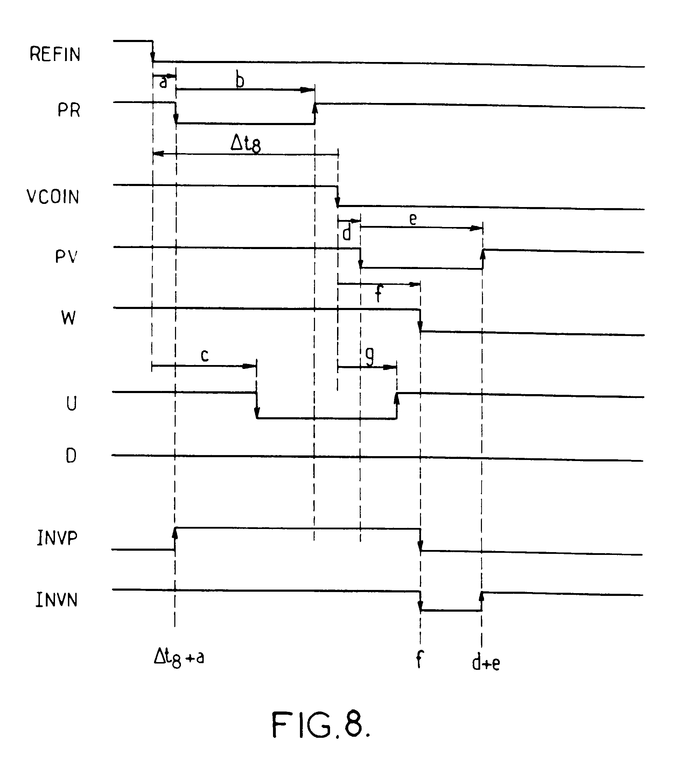

Le séquencement des signaux dans le comparateur de la figure 7 est illustré par les figures 8 à 11. Le retard a désigne l'intervalle de temps fixe séparant un front descendant du signal d'entrée REFIN et le front d'activation suivant du signal impulsionnel PR. On considère ici que le signal PR s'active au moment où il est susceptible de faire changer d'état l'un des signaux de commande INVP et INVN. Le retard a est donc le temps de réponse à un front descendant de REFIN de la chaîne logique constituée par les éléments 82, 98, 130, 128 et 122 ou par les éléments 82, 98, 130, 128, 132 et 124. La durée b désigne la durée fixe d'activation du signal impulsionnel PR après un front descendant de REFIN. Elle correspond au temps de réponse de la chaîne constituée par les éléments 84, 86, 94, 88, 90, 96 et 92. Le retard c désigne l'intervalle de temps séparant un front descendant de REFIN et le front d'activation suivant du premier signal de détection U ou le front de désactivation suivant du second signal de détection D. On considère ici que le front descendant de U (ou le front montant de D) survient au moment où il est susceptible de faire changer d'état l'un des signaux de commande INVP, INVN. Le retard c correspond donc au temps de réponse à un front descendant de REFIN de la chaîne constituée par les éléments 82, 84, 86, 94, 88, 10 et 122 ou par les éléments 82, 84, 86, 94, 88, 10, 138, 136, 134 et 124. Les retards a, b et c ne sont pas connus avec une grande précision en raison notamment des incertitudes sur les temps de réponse des éléments logiques. Mais on peut sans difficulté dimensionner les condensateurs 94, 96 et les transistors des portes logiques du générateur d'impulsions 80 de façon à ce que chaque front d'activation de U et chaque front de désactivation de D surviennent pendant que le signal impulsionnel PR est actif. Le générateur 80 est donc dimensionné de façon à réaliser $0 \leq a < c < a+b$.

Le retard d désigne l'intervalle de temps fixe séparant un front descendant du signal d'entrée VCOIN et le front d'activation suivant du signal impulsionnel PV. On considère ici que le signal PV s'active au moment où il est susceptible de faire changer d'état l'un des signaux de commande INVP et INVN. Le retard d est donc le temps de réponse à un front descendant de VCOIN de la chaîne logique constituée par les éléments 102, 112, 130, 128 et 122 ou par les éléments 102, 112, 130, 128, 132 et 124. La durée e désigne la durée fixe d'activation du signal impulsionnel PV après un front descendant de VCOIN. Elle correspond au temps de réponse de la chaîne constituée par les éléments 104, 106, 110 et 108. Le retard f désigne l'intervalle de temps fixe séparant un front descendant de VCOIN et le passage suivant du signal de séparation W du niveau 1 au niveau 0. On considère ici que le signal W passe du niveau 1 au niveau 0 au moment où il est susceptible de faire changer d'état l'un des signaux de commande INVP, INVN. Le retard f correspond donc au temps de réponse à un front descendant de VCOIN de la chaîne constituée par les éléments 102, 104, 106, 110, 108, 126 et 122 ou par les éléments 102, 104, 106, 110, 108, 126 et 124. Le retard g désigne l'intervalle de temps séparant un front descendant de VCOIN et le front d'activation suivant du second signal de détection D ou le front de désactivation suivant du premier signal de détection U. On considère ici que le front descendant de D (ou le front montant de U) survient au moment où il est susceptible de faire changer d'état l'un des signaux de commande INVP, INVN. Le retard g correspond donc au temps de réponse à un front descendant de VCOIN de la chaîne constituée par les éléments 102, 104, 10 et 122 ou par les éléments 102, 104, 10, 138, 136, 134 et 124. Les retards d, e, f, g ne sont pas connus avec une grande précision en raison notamment des incertitudes sur les temps de réponse des éléments logiques. Mais on peut sans difficulté dimensionner le condensateur 110 et les transistors des portes logiques du générateur d'impulsions 100 de façon à ce que chaque front d'activation de D, chaque front de désactivation de U et chaque passage du signal de séparation W du niveau 1 au niveau 0 surviennent pendant que le signal impulsionnel PV est actif. Le générateur 100 est donc dimensionné de façon à réaliser

$0 \leq d < f < d+e$ et $d < g < d+e$.

Le schéma de la figure 7 correspond au cas où $f \geq g$ (si $f < g$, la logique de commande doit être modifiée pour réaliser, par exemple, INVP $= (\overline{U}\ ET\,PV)\ OU\,[W\ ET\,(\overline{PR}\ OU\,\overline{PV})]$ et $\overline{INVN} = \overline{D}\ OU\,[\overline{W}\ ET\,(\overline{PR}\ OU\,\overline{PV})]$). Dans le cas de la figure 7, lorsque l'un des signaux impulsionnels PR, PV est actif (PR=0 ou PV=0), la logique de commande 120 réalise INVP $= \overline{U}\ OU\,W = W$ et $\overline{INVN} = (\overline{D}\ ET\,PV)\ OU\,\overline{W} = \overline{W}$. Le premier signal de commande INVP est donc actif (INVP=1) si le signal de séparation W est au niveau 1, tandis que le second signal de commande INVN est actif (INVN=0) si le signal de séparation W est au niveau 0. Lorsqu'aucun des signaux impulsionnels PR, PV n'est actif (PR=PV=1), la logique de commande 120 réalise INVP=$\overline{U}$ et INVN=$\overline{D}$. Le premier signal de commande INVP est donc actif (INVP=1) si le premier signal de détection U est actif (U=0), tandis que le second signal de commande INVN est actif (INVN=0) si le second signal de commande D est actif (D=0).

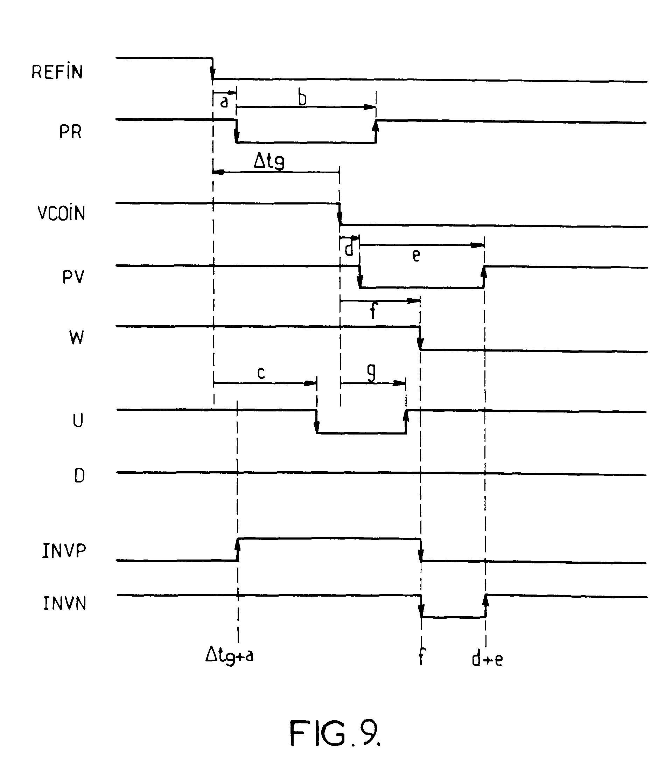

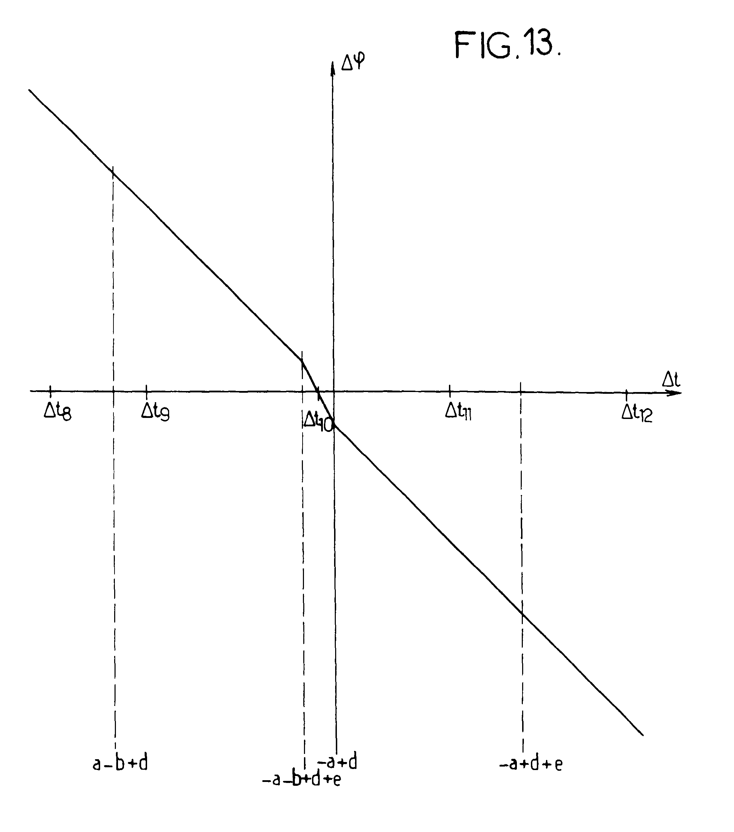

Dans l'exemple illustré sur les figures 8 à 13, la durée b d'activation du signal PR est plus grande que la durée e d'activation du signal PV. Les chronogrammes des figures 8 et 9 correspondent à un décalage temporel $\Delta t_8$, $\Delta t_9$ inférieur à $-a-b+d+e$ entre les fronts descendants de VCOIN et de REFIN ($\Delta t > 0$ quand le front descendant de VCOIN précède celui de REFIN). Pour $\Delta t \leq -a-b+d+e$, le signal INVP est actif de $\Delta t+a$ à f (l'instant 0 est considéré comme celui du front descendant de VCOIN), et le signal INVN est actif de f à d+e. La variation $\Delta\varphi$ de la tension de sortie est donc proportionnelle à $-\Delta t-a-d-e+2f$ (partie gauche de la figure 13).

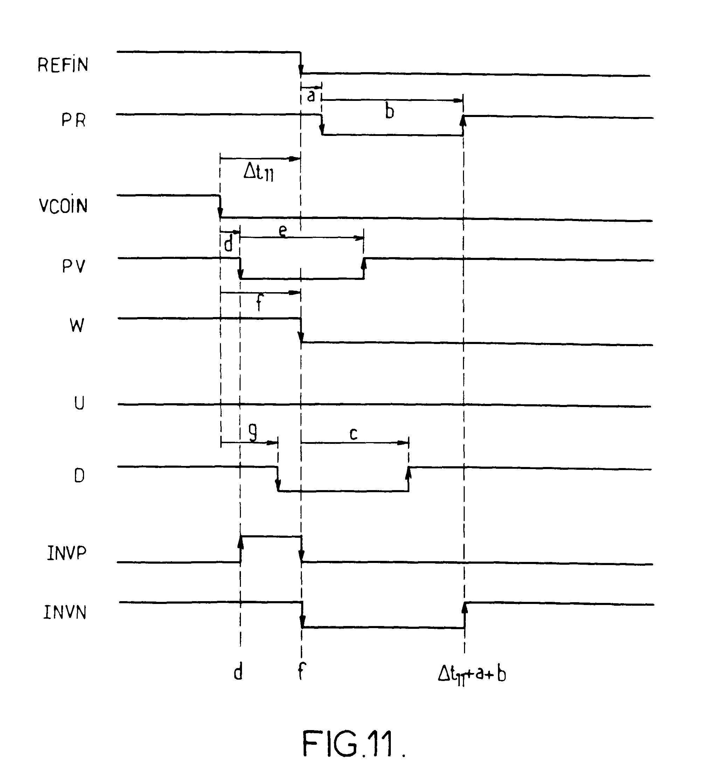

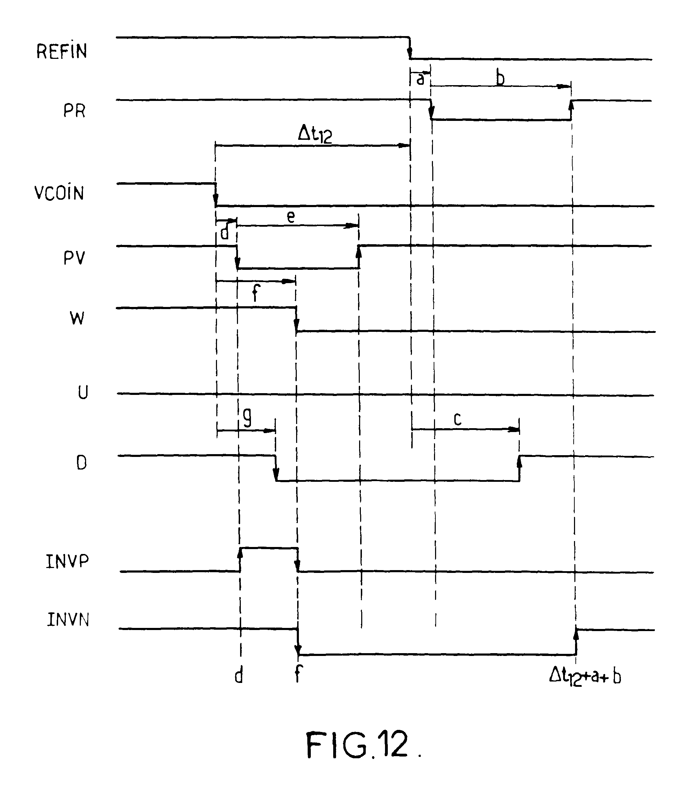

Les chronogrammes des figures 11 et 12 correspondent à un décalage temporel $\Delta t_{11}$, $\Delta t_{12}$ supérieur à $-a+d$ entre les fronts descendants de VCOIN et de REFIN. Pour $\Delta t \geq -a+d$, le signal INVP est actif de d à f, et le signal INVN est actif de f à $\Delta t+a+b$. La variation $\Delta\varphi$ de la tension de sortie est donc proportionnelle à $-\Delta t-a-b-d+2f$ (partie droite de la figure 13).

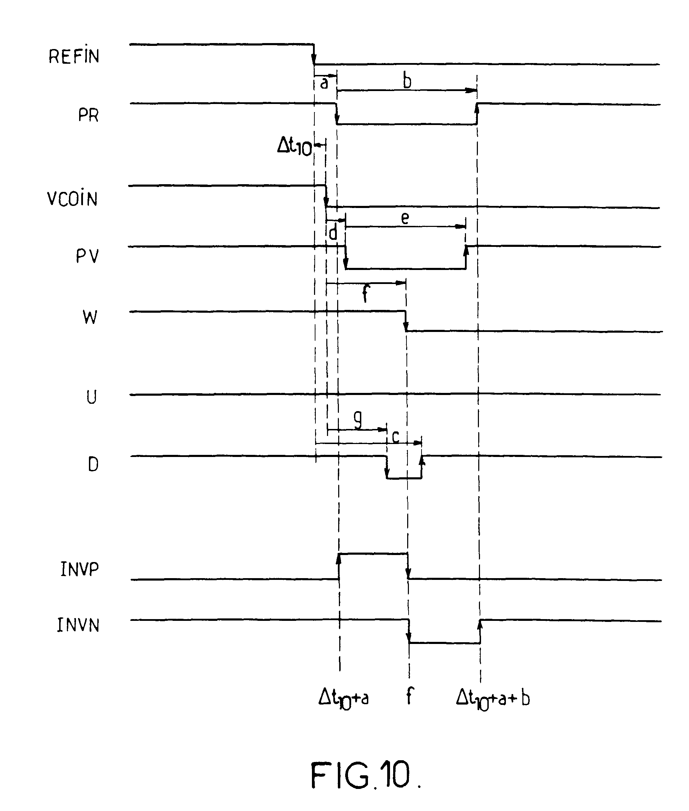

Le chronogramme de la figure 10 correspond à un décalage temporel $\Delta t_{10}$ supérieur à $-a-b+d+e$ et inférieur à $-a+d$ (l'impulsion de PR recouvre entièrement l'impulsion de PV). Pour $-a-b+d+e \leq \Delta t \leq -a+d$, le signal INVP est actif de $\Delta t+a$ à f, et le signal INVN est actif de f à $\Delta t+a+b$. La variation $\Delta\varphi$ de la tension de sortie est donc proportionnelle à $-2\Delta t-2a-b+2f$.

La caractéristique ($\Delta t$, $\Delta\varphi$) du comparateur de phase, représentée sur la figure 13, est linéaire avec un gain constant, sauf dans une fenêtre $-a-b+d+e \leq \Delta t \leq -a+d$ où le gain est double.

On note que dans les cas des figures 9, 10 et 11 ($-a-b+d \leq \Delta t \leq -a+d+e$, c'est-à-dire que les impulsions actives de PR et PV présentent un recouvrement), l'activation des signaux de commande INVP, INVN dépend seulement des signaux impulsionnels PR et PV qui ont des durées d'activation fixes, et du signal de séparation W. Les signaux de détection U et D n'interviennent que pour les décalages temporels relativement importants : $\Delta t < -a-b+d$ (figure 8) ou $\Delta t > -a+d+e$ (figure 12). Les durées d'activation des signaux U et D sont respectivement max(0,-Δt-c+g) et max(0,Δt+c-g). Toute impulsion du signal U plus courte que a+b-c-d+g (>0 car a+b>c et g>d) n'est donc pas vue par le comparateur, de même que toute impulsion du signal D plus courte que -a+c+d+e-g (>0 car c>a et d+e>g). De cette façon, le comparateur de phase de la figure 7 élimine le problème de la zone morte qu'on rencontre dans les comparateurs classiques dans les cas d'activations très courtes des signaux de détection.

On note également que, dans tous les cas, le signal de commande INVP est activé pendant une durée au moins égale à f-d, et que l'autre signal de commande INVN est activé pendant une durée au moins égale à d+e-f. On écarte ainsi tout problème d'incertitude que pourrait poser une activation trop courte de l'un des signaux de commande INVP, INVN.

Comme on l'a déjà mentionné, la figure 7 ne montre qu'un exemple de réalisation des générateurs de signaux impulsionnels 80,100 et de la logique de commande 120, auquel diverses variantes peuvent être apportées sans sortir du cadre de la présente invention. Par exemple, la génération des signaux PR, PV, W et INVP étant inchangée par rapport au cas de la figure 7, la logique de commande pourrait être modifiée de façon à réaliser :

$$\overline{INVN} =$$

$$(\overline{D}\ ET\ PV\ ET\ PR)\ OU\ [\overline{W}\ ET\ (\overline{PR}\ OU\ \overline{PV})] \qquad (3)$$

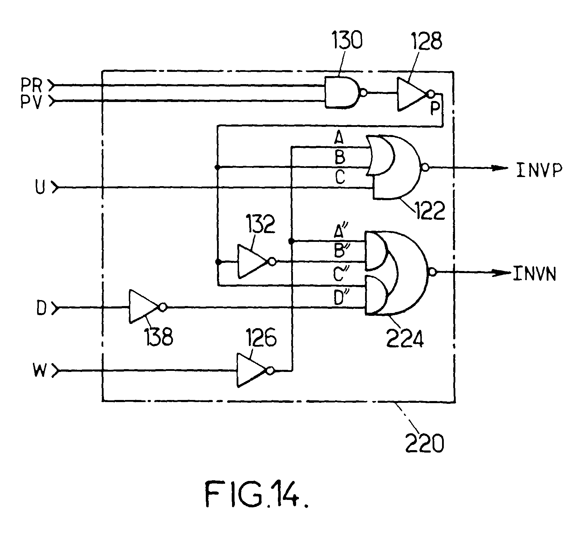

La figure 14 montre une logique de commande de transfert de charges 220 apte à mettre en oeuvre les relations (1) et (3) pour produire les signaux de commande INVP et INVN. Cette logique 220 comporte quelques éléments identiques à des éléments de la figure 7, dont on a réutilisé les références numériques 122, 126, 128, 130, 132 et 138. Le signal INVN est délivré par une porte logique composite à quatre entrées qui réalise l'opération logique $\overline{INVN} = (A''\ ET\ B'')\ OU\ (C''\ ET\ D'')$ entre les signaux A'', B'', C'' et D'' parvenant respectivement à ses quatre entrées. Les signaux A'', B'', C'' et D'' sont respectivement ceux fournis par les inverseurs 126, 132, 128 et 138.

On peut vérifier, en observant les figures 8 à 12, que l'opération (3) réalisée par la logique 220 de la figure 14 est équivalente à l'opération (2) réalisée par la logique 120 de la figure 7. En effet, $\underline{D}$=PV=1 implique $\overline{W}$=1, dès lors que le dimensionnement du générateur d'impulsions 100 est tel que d<g et f<d+e.

**Revendications**

1. Comparateur de phase entre des premier et second signaux binaires d'entrée (REFIN, VCOIN), comprenant :

- une logique de détection de déphasage (10) recevant les signaux d'entrée avec des retards prédéterminés respectifs, et délivrant d'une part un premier signal de détection (U) activé, après un front actif au premier signal d'entrée retardé (R) précédant un front actif du second signal d'entrée retardé (V), pendant une durée correspondant à l'intervalle de temps entre lesdits fronts actifs des signaux d'entrée retardés, et d'autre part un second signal de détection (D) activé, après un front actif du second signal d'entrée retardé (V) précédant un front actif du premier signal d'entrée retardé (R), pendant une durée correspondant à l'intervalle de temps entre lesdits fronts actifs des signaux d'entrée retardés

- un premier générateur de signal impulsionnel (80), produisant un premier signal impulsionnel (PR) présentant une impulsion active de durée fixe (b) après chaque front actif du premier signal d'entrée (REIN), de manière à ce que chaque front d'activation du premier signal de détection (U) et chaque front de désactivation du second signal de détection (D) surviennent pendant que le premier signal impulsionnel (PR) est actif ;

- une logique de commande de transfert de charges (120) combinant au moins les signaux de détection (U,D) et le premier signal impulsionnel (PR), et produisant des premier et second signaux de commande (INVP, INVN) non simultanément actifs ; et

- un circuit formant pompe de charge (22) pour faire varier dans un sens la valeur d'une tension de sortie (φ) lorsque le premier signal de commande (INVP) est actif et pour faire varier dans l'autre sens la valeur de la tension de sortie (φ) lorsque le second signal de commande (INVN) est actif,

caractérisé en ce qu'il comprend des moyens (116) pour produire un signal de séparation (W) passant d'un premier niveau à un second niveau avec un retard fixe (f) après chaque front actif du second signal d'entrée (VCOIN), et un second générateur de signal impulsionnel (100), produisant un second signal impulsionnel (PV) présentant une impulsion active de durée fixe (e) après chaque front actif du second signal d'entrée (VCOIN), de manière à ce que chaque front de désactivation du premier signal de détection (U), chaque front d'activation du second signal de détection (D) et chaque passage du signal de séparation (W) du premier au second niveau surviennent pendant que le second signal impulsionnel (PV) est actif, et en ce que la logique de commande (120) combine les premier et second signaux de détection (U,D), les premier et second signaux impulsionnels (PR,PV) et le signal de séparation (W) de manière à ce que, pendant que l'un au moins des signaux impulsionnels (PR, PV) est actif, le premier signal de commande (INVP) soit actif si le signal de séparation (W) est au premier niveau, et le second signal de commande (INVN) soit actif si le signal de séparation (W) est au second niveau.

2. Comparateur de phase selon la revendication 1, caractérisé en ce que la logique de commande (120) combine les premier et second signaux de détection (U,D), les premier et second signaux impulsionnels (PR, PV) et le signal de séparation (W) de manière à ce que, pendant qu'aucun des premier et second signaux impulsionnels (PR, PV) n'est actif, le premier signal de commande (INVP) soit actif si le premier signal de détection (U) est actif, et le second signal de commande (INVN) soit actif si le second signal de détection (D) est actif.

**Patentansprüche**

1. Phasenkomparator zwischen einem ersten und einem zweiten binären Eingangssignal (REFIN, VCOIN), welcher

   - einen Logikschaltkreis (10) zur Detektion einer Phasenverschiebung, der die Eingangssignale mit einer jeweils vorher festgelegten Verzögerung empfängt und einerseits während einer Dauer, die dem Zeitintervall zwischen den aktiven Fronten der verzögerten Eingangssignale entspricht, ein erstes Detektionssignal (U) liefert, welches nach einer aktiven Front des ersten verzögerten Eingangssignals (R) ausgelöst wird, das einer aktiven Front des zweiten verzögerten Eingangssignals (V) vorhergeht, und andererseits während einer Dauer, die dem Zeitintervall zwischen den aktiven Fronten der verzögerten Eingangssignale entspricht, ein zweites Detektionssignal (D) liefert, welches nach einer aktiven Front des zweiten verzögerten Eingangssignals (V) ausgelöst wird, das einer aktiven Front des ersten verzögerten Eingangssignals (R) vorhergeht,

   - einen ersten Impulssignalgenerator (80), der ein erstes Impulssignal (PR) erzeugt, das einen aktiven Impuls mit fester Dauer (b) nach der jeweiligen aktiven Front des ersten Eingangssignals (REFIN) derart besitzt, daß die jeweilige Aktivierungsfront des ersten Detektionssignal (U) und die jeweilige Desaktivierungsfront des zweiten Detektionssignals (D) auftreten, während das erste Impulssignal (PR) aktiv ist,

   - einen Steuerlogikschaltkreis (120) für den Ladungstransport, welcher wenigstens die Detektionssignale (U, D) und das erste Impulssignal (PR) vereinigt und das erste (INVP) und das zweite Steuersignal (INVN) erzeugt, die nicht gleichzeitig aktiv sind, und

   - einen eine Ladungspumpe bildenden Schaltkreis (22), um den Wert einer Ausgangsspannung (φ) in einer Richtung zu variieren, wenn das erste Steuersignal (INVP) aktiv ist, und um den Wert der Ausgangsspannung (φ) in die andere Richtung zu variieren, wenn das zweite Steuersignal (INVN) aktiv ist, umfaßt,

   **dadurch gekennzeichnet, daß** er Mittel (116), um ein Trennsignal (W) zu erzeugen, das nach der jeweiligen aktiven Front des zweiten Eingangssignals (VCOIN) mit einer festen Verzögerung (f) von einem ersten zu einem zweiten Niveau übergeht, und einen zweiten Impulssignalgenerator (PV) umfaßt, der einen aktiven Impuls mit fester Dauer (e) nach der jeweiligen aktiven Front des zweiten Eingangssignals (VCOIN) derart besitzt, daß die jeweilige Desaktivierungsfront des ersten Detektionssignals (U), die jeweilige Aktivierungsfront des zweiten Detektionssignals (D) und der jeweilige Übergang des Trennsignals (w) vom ersten zum zweiten Niveau auftritt, während das zweite Impulssignal (PV) aktiv ist, **und daß** der Steuerlogikschaltkreis (120) das erste und das zweite Detektionssignal (U, D), das erste und das zweite Impulssignal (PR, PV) und das Trennsignal (W) so vereinigt, daß, während mindestens eines der Impulssignale (PR, PV) aktiv ist, das erste Steuersignal (INVP) aktiv ist, wenn sich das Trennsignal (W) auf dem ersten Niveau befindet, und das zweite Steuersignal (INVN) aktiv ist, wenn sich das Trennsignal (W) auf dem zweiten Niveau befindet.

2. Phasenkomparator nach Anspruch 1, **dadurch gekennzeichnet, daß** der Steuerlogikschaltkreis (120) das erste und das zweite Detektionssignal (U, D), das erste und das zweite Impulssignal (PR, PV) und das Trennsignal (w) so vereinigt, daß, während weder das erste noch das zweite Impulssignal (PR, PV) aktiv ist, das erste Steuersignal (INVP) aktiv ist, wenn das erste Detektionssignal (U) aktiv ist, und das zweite Steuersignal (INVN) aktiv ist, wenn das zweite Detektionssignal (D) aktiv ist.

**Claims**

1. A phase comparator between first and second binary input signals (REFIN, VCOIN), comprising:

   - a phase shift detection logic (10) receiving the input signals with respective predetermined delays and delivering on the one hand a first detection signal (U) activated, after an active front of the first delayed input signal (R) preceding an active front of the second delayed input signal (V), for a period of time corresponding to the time lapse between the said active fronts of the delayed input signals, and on the other a second detection signal (D) activated, after an active front of the second delayed input signal (V) preceding an active front of the first delayed input signal (R), for a period of time corresponding to the time lapse between the said active fronts of the delayed input signals;

- a first impulse signal generator (80) producing a first impulse signal (PR) having an active pulse of fixed duration (b) after each active front of the first input signal (REFIN), so that each activation front of the first detection signal (U) and each deactivation front of the second detection signal (D) occur while the first impulse signal (PR) is active;

- a charge transfer control logic (120) combining at least the detection signals (U, D) and the first impulse signal (PR) and producing first and second non-simultaneously active control signals (INVP, INVN); and

- a charge pump circuit (22) for causing the value of an output voltage (φ) to vary in one direction when the first control signal (INVP) is active and for causing the value of the output voltage (φ) to vary in the other direction when the second control signal (INVN) is active,

characterised in that it comprises means (116) of producing a separation signal (W) passing from a first level to a second level with a fixed delay (f) after each active front of the second input signal (VCOIN), and a second impulse signal generator (100) producing a second impulse signal (PV) having an active pulse of fixed duration (e) after each active front of the second input signal (VCOIN), so that each deactivation front of the first detection signal (U), each activation front of the second detection signal (D) and each passage of the separation signal (W) from the first to the second level occur while the second impulse signal (PV) is active, and in that the control logic (120) combines the first and second detection signals (U, D), the first and second impulse signals (PR, PV) and the separation signal (W) so that while one at least of the impulse signals (PR, PV) is active, the first control signal (INVP) is active if the separation signal (W) is at the first level and the second control signal (INVN) is active if the separation signal (W) is at the second level.

2. A phase comparator according to Claim 1, characterised in that the control logic (120) combines the first and second detection signals (U, D), the first and second impulse signals (PR, PV) and the separation signal (W) so that while neither of the first and second impulse signals (PR, PV) is active, the first control signal (INVP) is active if the first detection signal (U) is active and the second control signal (INVN) is active if the second detection signal (D) is active.

FIG.1.

# FIG. 2.

# FIG.3.

# FIG.4.

LOGIQUE DE
DÉTECTION DE
DÉPHASAGE

POMPE
DE
CHARGE

FIG.5.

FIG.6.

FIG.7

FIG.8.

FIG.9.

FIG.10.

FIG.11.

FIG.12.

FIG.13.

FIG.14.